# EUROPEAN PATENT APPLICATION

(11) **EP 3 104 416 A1**
(43) Date of publication of application: **14.12.2016**
(21) Application number: 15171088.6
(22) Date of filing: 09.06.2015
(51) Int. Cl.: H01L 29/778, H01L 29/423, H01L 29/417, H01L 29/16, G01N 27/414

(54) **AN APPARATUS FOR FIELD EFFECT TRANSISTOR BASED DEVICES AND ASSOCIATED METHODS**

(71) Applicant: Nokia Technologies Oy, 02610 Espoo (FI)
(72) Inventor: Allen, Mark, Cambs, CB23 6AA (GB); White, Richard, Huntingdon, Cambridgeshire PE28 9DY (GB)
(74) Representative: Nokia Corporation

(57) **Abstract**

An apparatus comprising: a drain electrode (102), a source electrode (104), and a channel layer (106), the drain electrode and source electrode in respective electrical contact with the channel layer to allow a flow of charge carriers between the source electrode and the drain electrode using the channel layer, the channel layer having opposing substrate and functionalisation sides; a channel gate (112) configured to modulate the conductivity of the channel layer via application of a voltage thereto; and at least one contact gate (114, 116) configured to lower a contact resistance between the channel layer and at least one of the source electrode and the drain electrode via application of a voltage thereto; wherein the channel gate and the at least one contact gate are provided on the substrate side, opposing the functionalisation side, of the channel layer.

## Description

### Technical Field

The present disclosure relates to the field of electronic devices and sensors, associated methods and apparatus, including graphene based electronics and in particular concerns an apparatus comprising a drain electrode, a source electrode, and a channel layer, the drain electrode and source electrode in respective electrical contact with the channel layer to allow a flow of charge carriers between the source electrode and the drain electrode using the channel layer and associated gate electrodes. Such apparatus are particularly suitable for use as field effect transistors. Certain disclosed aspects/examples relate to portable electronic devices, in particular, so-called hand-portable electronic devices which may be hand-held in use (although they may be placed in a cradle in use). Such hand-portable electronic devices include mobile telephones, so-called Personal Digital Assistants (PDAs), smartphones and other smart devices, and tablet PCs.

The portable electronic devices/apparatus according to one or more disclosed examples may provide one or more audio/text/video communication functions (e.g. tele-communication, video-communication, and/or text transmission (Short Message Service (SMS)/Multimedia Message Service (MMS)/e-mailing) functions), interactive/non-interactive viewing functions (e.g. web-browsing, navigation, TV/program viewing functions), music recording/playing functions (e.g. MP3 or other format and/or (FM/AM) radio broadcast recording/playing), downloading/sending of data functions, image capture functions (e.g. using a (e.g. in-built) digital camera), and gaming functions.

### Background

Research is being done into two-dimensional materials, e.g., graphene, particularly for use in field effect transistors.

The listing or discussion of a prior-published document or any background in this specification should not necessarily be taken as an acknowledgement that the document or background is part of the state of the art or is common general knowledge. One or more aspects/examples of the present disclosure may or may not address one or more of the background issues.

### Summary

According to a first aspect, there is provided an apparatus comprising: a drain electrode, a source electrode, and a channel layer, the drain electrode and source electrode in respective electrical contact with the channel layer to allow a flow of charge carriers between the source electrode and the drain electrode using the channel layer, the channel layer having opposing substrate and functionalisation sides; a channel gate configured to modulate the conductivity of the channel layer via application of a voltage thereto; and at least one contact gate configured to lower a contact resistance between the channel layer and at least one of the source electrode and the drain electrode via application of a voltage thereto; wherein the channel gate and the at least one contact gate are provided on the substrate side, opposing the functionalisation side, of the channel layer.

The source electrode and the drain electrode may be located adjacent to the channel layer on the substrate side of the channel layer. The source electrode and the drain electrode may be located adjacent to the channel layer on the functionalisation side of the channel layer. One of the source and drain electrodes may be located adjacent to the channel layer on the substrate side of the channel layer and the other of the source and drain electrodes may be located adjacent to the channel layer on the functionalisation side of the channel layer.

The channel layer may be a two-dimensional material. The channel layer may comprise graphene.

The channel gate and the at least one contact gate may be coplanar.

The at least one contact gate may be a global gate configured to lower the contact resistance between the channel layer and both the source electrode and the drain electrode via application of a voltage thereto.

The channel gate may be located between the channel layer and the global contact gate.

The channel gate may be embedded in a dielectric layer located on the substrate side of the channel layer, between the channel layer and the at least one contact gate.

The at least one contact gate may be embedded in a dielectric layer located on the substrate side of the channel layer.

The apparatus may comprise a dielectric layer adjacent to the substrate side of the channel layer, the dielectric layer sandwiched between the channel layer and a doped semiconducting (non-dielectric) layer.

The at least one contact gate and the channel gate may be embedded in different planes in a dielectric on the substrate side of the channel layer. The channel gate may be located closer to the channel layer than the at least one contact gate.

The source electrode, the drain electrode, the channel gate and the channel layer may be configured as part of a field effect transistor (FET).

The apparatus may comprise a plurality of source electrodes and/or a plurality of drain electrodes.

The channel layer may be functionalised by the addition to the functionalisation side of the channel layer of molecules such that the apparatus is configured for use as a biosensor, and/or quantum dots such that the apparatus is configured for use as an optical sensor.

The apparatus may be a circuit board, a sensor, a biosensor, an optical sensor, an electronic device, a portable electronic device, a portable telecommunications device, a mobile phone, a personal digital assistant, a tablet, a desktop computer, a laptop computer, a server, a smartphone, a smartwatch, smart eyewear, a medical imaging device, a night-vision device, or a module for one or more of the same.

According to a further aspect, there is provided a method for forming an apparatus comprising providing respective at least one contact gate, a channel gate, a channel layer, a drain electrode and a source electrode such that:
the channel layer is in contact respectively with the drain electrode and the source electrode to allow a flow of charge carriers between the source electrode and the drain electrode using the channel layer, the channel layer having opposing substrate and functionalisation sides;
the channel gate is configured to modulate the conductivity of the channel layer via application of a voltage thereto,
the at least one contact gate is configured to lower a contact resistance between the channel layer and at least one of the source electrode and the drain electrode via application of a voltage thereto; and
the channel gate and the at least one contact gate are provided on the substrate side, opposing the functionalisation side, of the channel layer.

The steps of any method disclosed herein do not have to be performed in the exact order disclosed, unless explicitly stated or understood by the skilled person.

Throughout the present specification, descriptors relating to relative orientation and position, such as "top", "bottom", "upper", "lower", "above" and "below", as well as any adjective and adverb derivatives thereof, are used in the sense of the orientation of the apparatus as presented in the drawings. However, such descriptors are not intended to be in any way limiting to an intended use of the described examples.

Corresponding computer programs for implementing one or more steps of the methods disclosed herein are also within the present disclosure and are encompassed by one or more of the described examples.

One or more of the computer programs may, when run on a computer, cause the computer to configure any apparatus or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

One or more of the computer programs may be provided on a computer readable medium, which may be a physical computer readable medium such as a disc or a memory device, or may be embodied as a transient signal. Such a transient signal may be a network download, including an internet download.

The present disclosure includes one or more corresponding aspects, examples or features in isolation or in various combinations whether or not specifically stated (including claimed) in that combination or in isolation. Corresponding means and corresponding functional units (e.g., contact gater, channel gater) for performing one or more of the discussed functions are also within the present disclosure.

The above summary is intended to be merely exemplary and non-limiting.

### Brief Description of the Figures

A description is now given, by way of example only, with reference to the accompanying drawings, in which:
Figures 1 a and 1 b show examples of the present apparatus having one source electrode and one drain electrode located on the substrate side of the channel layer;
Figures 2a and 2b show examples of the present apparatus having one source electrode and one drain electrode located on the functionalisation side of the channel layer;
Figures 3a and 3b show examples of the present apparatus having two source electrodes and two drain electrodes located on the substrate side of the channel layer;
Figures 4a and 4b show examples of the present apparatus having two source electrodes and two drain electrodes located on the functionalisation side of the channel layer;
Figure 5 shows an example of the present apparatus having source and drain electrodes each located on the functionalisation and substrate sides of the channel layer;
Figure 6 shows schematically another example of the present apparatus;
Figure 7 shows a method of making the present apparatus as a flow chart; and
Figure 8 shows a computer-readable medium comprising a computer program configured to perform, control or enable a method described herein.

### Description of Examples

The present disclosure relates to an apparatus for use in electronics, particularly those based on using two-dimensional materials such as graphene. Apparatus disclosed herein may be used as (in the example of using graphene as a two-dimensional material), graphene field-effect transistors and transducers (GFETs), GFET photodetectors and other GFET based sensors such as biosensors. The apparatus may be, or may form part of, a circuit board, a sensor, a biosensor, an optical sensor, an electronic device, a portable electronic device, a portable telecommunications device, a mobile phone, a personal digital assistant, a tablet, a desktop computer, a laptop computer, a server, a smartphone, a smartwatch, smart eyewear, a medical imaging device, a night-vision device, or a module for one or more of the same.

While the following discussion focuses on the use of graphene as a two-dimensional material for use as a channel layer in the apparatus, it will be understood by the skilled person that other suitable materials, including other two-dimensional materials, may be used as the channel layer and are included in the scope of this description. Two dimensional materials may be considered to comprise between one and five monolayers of conductive two-dimensional material.

Making good electrical contact to graphene may be considered a challenging issue. Charge transfer between metal (for example, a metal contact or metal electrode) and graphene may depend on the work function difference between the metal and graphene, chemical interaction between the metal and graphene, and carrier density in the graphene. Optimising the metal for use in contacting the graphene, in order to optimise the work function difference between the metal and the graphene, may improve electrical contact between the metal and the graphene, but this approach limits the metal which may be used. Larger differences in work function between the metal and graphene may give rise to smaller contact resistances. This can be understood by the metal causing the graphene region in contact with the metal to be either n- or p-doped due to the built-in field arising from the work function difference. Another approach for reducing the contact resistance between metal and graphene may be to anneal after contacting the graphene and metal to improve the electrical contact.

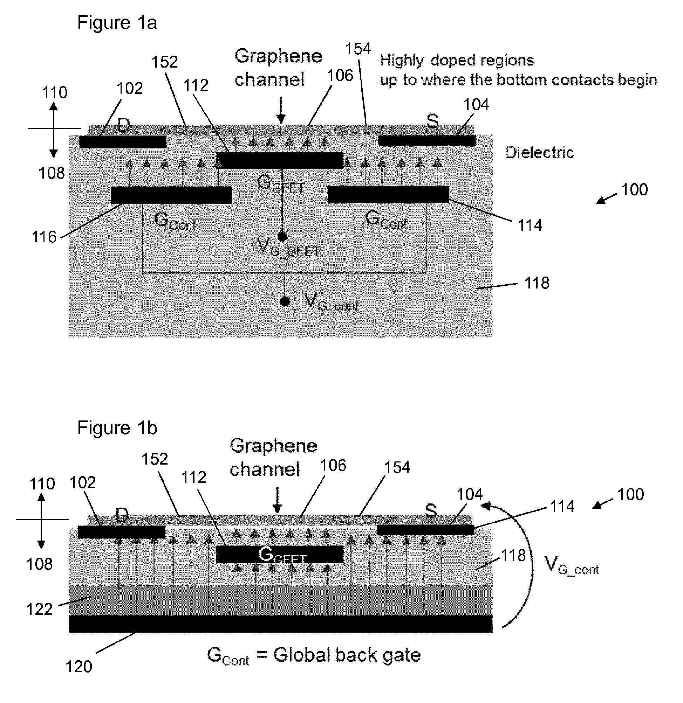

The apparatus of Figures 1a, 1b, 2a, 2b, 3a, 3b, 4a, 4b, 5 and 6 described later all comprise a source electrode, a drain electrode, a channel gate and a channel layer which may be configured as part of a field effect transistor (FET). The source and drain electrodes may also be labelled source and drain contacts. In the case where the channel layer is or comprises graphene, the apparatus may be considered to be a graphene field effect transistor or graphene-based field effect transistor (GFET). The examples described herein advantageously have a channel gate and one or more contact gates, located on the substrate side of the channel layer. In certain examples the source and drain electrodes may also be located on the substrate side of the channel layer. This location of gates (and electrodes in some examples) allows the channel layer surface to remain "bare", or more exposed (i.e., more/substantially free/available for functionalisation).

Firstly, because the deposition of the channel layer (which may be a two-dimensional material such as graphene) takes place as a final or near-final fabrication step after deposition of the gates and electrodes, minimal processing is required after the deposition of the channel layer. This allows for a minimum of handling while the channel layer is present in the apparatus, minimising the chances of damage to the channel layer. This also allows for a minimum of processing/further assembly required to take place after the channel layer is present in the apparatus, thereby minimising damage or degradation of the channel layer due to lithography or other deposition techniques taking place, for example by polymer residues remaining on the channel layer after further lithographic processing. Such damage, for example in the case of graphene, can result in very high contact resistivity of the graphene, which is undesirable.

Also, because the channel layer surface remains more/substantially exposed due to the location of the channel gate (and contact gates) on the substrate side of the channel layer (underneath the channel layer as shown in the figures), the exposed channel layer is (e.g., more) available for subsequent functionalisation. The exposed side of the channel layer may therefore be labelled the functionalisation side of the channel layer, because it remains exposed for further treatment such as functionalisation. For example, the resulting apparatus may be used as a sensor, exploiting the sensing capabilities of a functionalised channel layer. For example, the channel layer may be functionalised by the addition to the functionalisation side of molecules such that the apparatus is configured for use as a biosensor. As another example, quantum dots may be applied to the functionalisation side of the channel layer such that the apparatus may be configured for use as an optical sensor. Other examples are possible as the skilled person would understand, such as application of DNA, antibodies, and/or hydrophobins to the functionalisation side of the channel layer.

If the channel layer is not to be functionalised, the apparatus may, for example, have a protective capping layer (a passivation layer) applied to the functionalisation side of the channel layer to protect it from damage and environmental/humidity exposure (such as a transparent dielectric and/or ceramic layer). For example, if the apparatus is or forms part of a high-frequency transistor (for which is may be desirable to reduce contact resistance between electrode and a channel layer) there may not be a functionalisation layer applied to the functionalisation side of the channel layer. In this case the high-frequency transistor may be coated with a dielectric layer acting as a passivation layer.

The apparatus of Figures 1a, 1b, 2a, 2b, 3a, 3b, 4a, 4b, 5 and 6 comprise one or more contact gates configured to gate the channel layer near/at the source/drain electrode regions where the channel layer is in contact with a source/drain electrode. The contact gate(s) allow for "contact gating" which is separate to "channel gating", thereby allowing the electric field at the contact/electrode regions to be controlled separately to the electric field at the channel region. This enables tuning of the Fermi level of the channel layer near the source/drain electrodes to significantly increase the doping level of the channel layer. The induced higher carrier density near/below the source/drain electrodes due to the contact gating provides a reduced contact resistivity between the (e.g., metal) source/drain electrodes and the channel layer compared with an apparatus with no contact gating. Further, the built-in potential due to work function differences between the channel layer and the source/drain electrodes may be advantageously reduced. The contact resistivity between the source/drain electrodes and the channel layer may include contributions from contact - channel layer and channel layer - channel layer resistivities.

The "channel gating" may be arranged to "shield" the channel layer from the high electric field induced by application of a voltage to the contact gate(s), and the apparatus may be biased to an optimal operating point (which in the case of a graphene FET transducer is usually at the point where transconductance is maximised). For example, the apparatus shown in Figures 1b, 2b, 3b and 4b all show a channel gate interposed between the channel layer and a common contact gate.

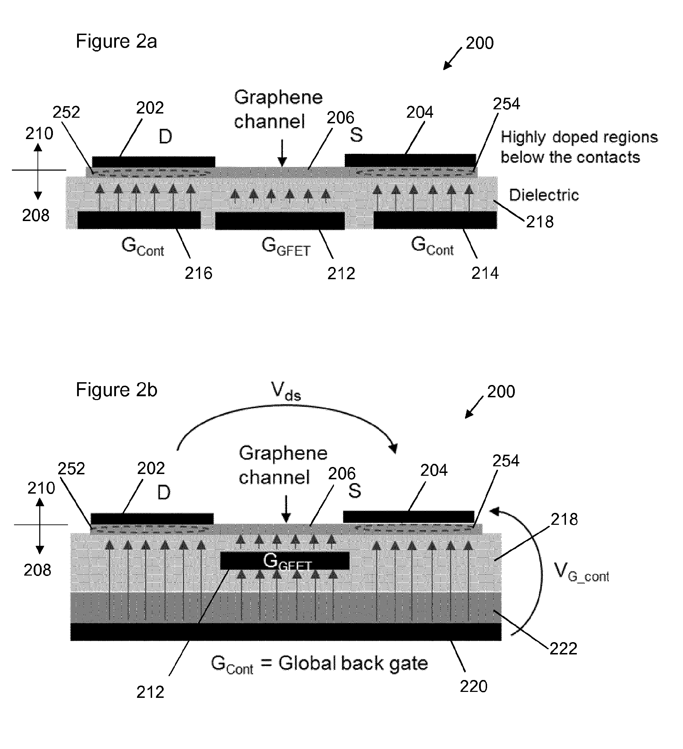

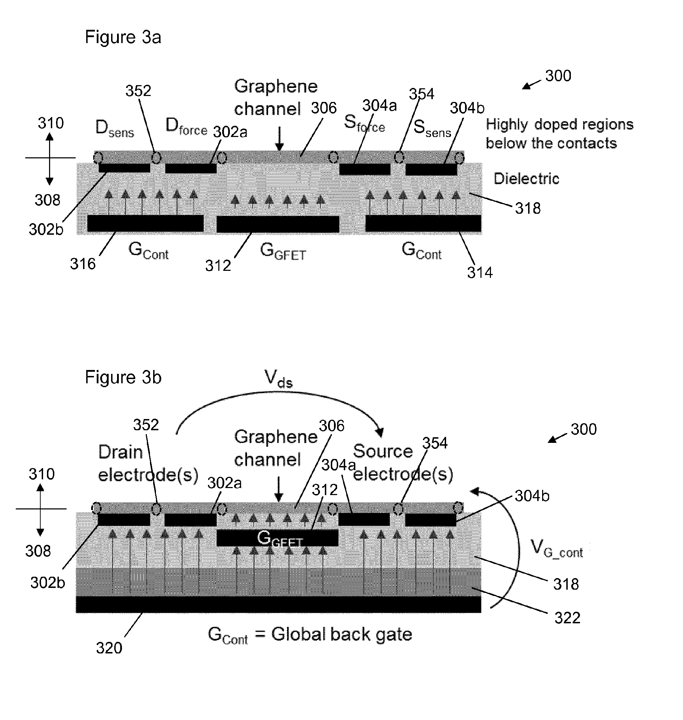

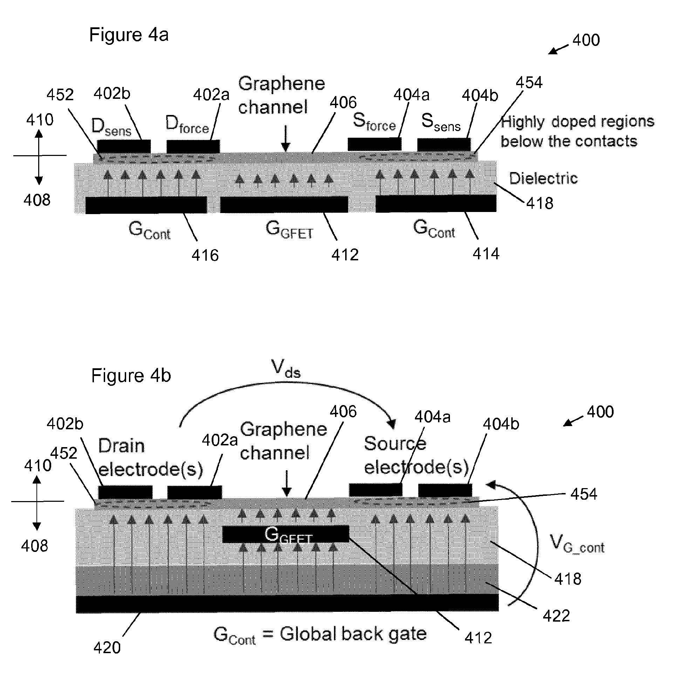

This approach may be applied to both top-contact examples wherein the source and drain electrodes are located on the functionalisation side of the channel layer, as shown in Figures 2a, 2b, 4a and 4b, and bottom-contact examples wherein the source and drain electrodes are located on the substrate side of the channel layer, as shown in Figures 1a, 1b, 3a and 3b. In the cases of four-electrode apparatus such as those shown in Figures 3a, 3b, 4a and 4b, where the contact resistance is deducted from the measured channel resistance, having as low as possible contact resistance is desirable in order to minimise power losses.

The polarity of the gating voltages applied to the source contact gate and the drain contact gate may be selected so that the channel layer near the contacts is either n- or p-doped.

Advantages of examples disclosed herein include the provision of an efficient means for reducing the contact resistance between source/drain electrodes and a channel layer, for example in the case of using metal contacts for source/drain electrodes and graphene for the channel layer. Further, the feasibility of bottom-only contact to the channel layer using a two-point architecture (wherein one source electrode and one drain electrode are used and located on the substrate side of the channel layer) is demonstrated, therefore giving cost advantages from a simplified process flow (e.g., compared with more than one source and/or more than one drain electrode).

Throughout the following description, similar features in the different examples are given corresponding reference numerals.

Figures 1 a and 1 b illustrate examples of an apparatus 100 according to the present disclosure in which a single drain electrode 102 and a single source electrode 104 are located on the substrate side 108 of the channel layer 106.

Figure 1a shows a drain electrode 102, a source electrode 104, and a channel layer 106. The drain electrode 102 and source electrode 104 are in respective electrical contact with the channel layer 106 to allow a flow of charge carriers between the source electrode 104 and the drain electrode 102 using the channel layer 106. The channel layer 106 has opposing substrate 108 and functionalisation 110 sides.

The skilled person will appreciate that a flow of charge carriers between the source electrode 104 and the drain electrode 102 may comprise, for example, electron flow from the source to the drain electrode (or electron flow from the drain electrode to the source electrode depending on the naming convention used). Other charge carriers may flow from one electrode to the other in some examples (for example, holes).

There is a channel gate G_{GFET} 112 configured to modulate the conductivity of the channel layer 106 via application of a voltage thereto, shown as V_{G_GFET}. In this example there are two separate contact gates, a source contact gate 114 and a drain contact gate 116. The contact gates 114, 116 are configured to lower the contact resistance between the channel layer 106 and the source and drain electrodes 104, 102 via application of a voltage thereto, shown as V_{G_cont}. The voltage V_{G_cont} applied to the contact gates is the same for both the source contact gate 114 and the drain contact gate 116. The voltage applied to the contact gates V_{G_cont} may be different to the voltage applied to the channel gate V_{G_GFET} (for example, the contact gate voltage V_{G_cont} may be larger than channel gate voltage V_{G_GFET}). The channel gate 112 and the source and drain contact gates 114, 116 are provided on the substrate side 108, opposing the functionalisation side 110, of the channel layer 106.

The source electrode 104 and the drain electrode 102 are located adjacent to the channel layer 106 on the substrate side 110 of the channel layer 106. Thus, in this example, the final fabrication step may be the deposition of the channel layer 106. This advantageously reduces any processing of the apparatus 100 after the application of the channel layer 106, thereby minimising the risk of damage to the channel layer 106.

In this example, the channel gate 112 is embedded in a dielectric layer 118 located on the substrate side 108 of the channel layer 106, laterally between the channel layer 106 and the source and drain contact gates 114, 116. An embedded gate may be called a buried gate. The source and drain contact gates 114, 116 are also embedded in the dielectric layer 118. In this example the source and drain contact gates 114, 116 and the channel gate 112 are embedded in different (vertical) planes in the dielectric 118 on the substrate side 108 of the channel layer 106, the channel gate 112 located closer to the channel layer 106 than the source and drain contact gates 114, 116.

Figure 1b shows another example, in which a common contact gate 120 is used compared with the separate source contact gate 114 and drain contact gate 116 of Figure 1a. Features in common with Figure 1a will not be discussed again in detail.

In this example there is a common contact gate 120 (which may also be called a global back gate shown as G_{cont} in the figures) which is configured to lower the contact resistance between the channel layer 106 and the source and drain electrodes 102, 104 via application of a voltage V_{G_cont} thereto. The channel gate 112 is embedded in a dielectric layer 118 located on the substrate side 108 of the channel layer 106, between the channel layer 106 and the common contact gate 120. In this example, the apparatus 100 comprises the dielectric layer 118 adjacent to the substrate side 108 of the channel layer 106 and the dielectric layer 118 is sandwiched between the channel layer 106 and a doped semiconducting (non-dielectric) layer 122. The doped semiconducting layer 122 is sandwiched between the dielectric layer 118 and the common contact gate 120.

In Figures 1 a and 1 b, the region of the channel layer laterally adjacent to the drain electrode 152 and the region of the channel layer adjacent to the source electrode 154 are channel layer regions which experience an increase in charge carrier density when a contact gate voltage V_{G_cont} is applied to the source and drain contact gates 114, 116 (figure 1a) or to the common contact gate 120 (figure 1 b). The Fermi level in these regions 152, 154 is tuned to increase the doping level in those regions of the channel layer 106. The induced higher carrier density due to increased doping levels provides a reduced contact resistivity between the source and drain electrodes 102, 104 and the channel layer 106 compared with an apparatus without contact gating. The higher carrier density regions 152, 154 in the channel layer 106 of Figure 1a have a line-of-sight substantially through the dielectric 118 to the underlying source and drain contact gates 114, 116 respectively. The higher carrier density regions 152, 154 in the channel layer 106 of Figure 1b have a line-of-sight substantially through the dielectric 118 and doped semiconducting layers 118 to the underlying common channel gate (global back gate) 120. The term "line-of-sight" between two objects is intended to mean that the electric field path between those two objects is not shielded or substantially disrupted by an electrically conducting object/layer.

Figures 2a and 2b illustrate examples of an apparatus 200 according to the present disclosure in which a single drain electrode 202 and a single source electrode 204 are located on the functionalisation side 210 of the channel layer 206. Features in common with previously described examples will not be discussed again in detail.

In the example of Figure 2a, there are two separate contact gates, a source contact gate 214 and a drain contact gate 216. The contact gates 214, 216 are configured to lower the contact resistance between the channel layer 206 and the source and drain electrodes 202, 204 via application of a voltage V_{G_cont} thereto. The source electrode 204 and the drain electrode 202 are located adjacent to the channel layer 206 on the functionalisation side of the channel layer 206.

In the example of Figure 2a, the channel gate 212, the source contact gate 214 and the drain contact gate 216 are coplanar, and all are embedded in a dielectric layer 218 located on the substrate side 208 of the channel layer 206. In some examples there may be further dielectric material beneath the channel gate 212 and contact gates 214, 216. In other examples, there may be a different material to the dielectric 218 beneath the channel gate 212 and contact gates 214, 216, such as a different dielectric material or a supporting substrate.

Figure 2b shows another example in which a common contact gate G_{Cont} 220 is used compared with the separate source contact gate 214 and drain contact gate 216 of Figure 2a. The source electrode 204 and the drain electrode 202 are located adjacent to the channel layer 206 on the functionalisation side 210 of the channel layer 206.

In this example, the common contact gate 220 is configured to lower the contact resistance between the channel layer 206 and the source and drain electrodes 202, 204 via application of a voltage V_{G_cont} thereto. The channel gate 212 is embedded in a dielectric layer 218 located on the substrate side 208 of the channel layer 206, between the channel layer 206 and the common contact gate 220. In this example, the apparatus 200 comprises the dielectric layer 218 adjacent to the substrate side 208 of the channel layer 206 and the dielectric layer 218 is sandwiched between the channel layer 206 and a doped semiconducting (non-dielectric) layer 222. The doped semiconducting layer 222 is sandwiched between the dielectric layer 218 and the common contact gate 220.

In Figures 2a and 2b, the region of the channel layer vertically adjacent to the drain electrode 252 and the region of the channel layer vertically adjacent to the source electrode 254 are channel layer regions which experience an increase in charge carrier density when a contact gate voltage V_{G_cont} is applied to the source and drain electrode(s) 202, 204. In comparison with Figures 1 a and 1 b, the regions 252, 254 are located in the channel layer 206 where the channel layer 206 is vertically adjacent to the overlying drain and source electrodes 202, 204. The higher carrier density in these regions 252, 254 of the channel layer 206 arises due to increased doping levels to provide a reduced contact resistivity between the source and drain electrodes 202, 204 and the channel layer 206 compared with an apparatus without contact gating.

Figures 3a and 3b illustrate examples of an apparatus 300 according to the present disclosure in which multiple drain electrodes 302a, 302b and multiple source electrodes 304a, 304b are located on the substrate side 308 of the channel layer 306. Features in common with previously described examples will not be discussed again in detail.

Figure 3a shows an example with features in common with the example shown in Figure 1a. In this example, there are a plurality of (two) source electrodes 304a, 304b and a plurality of (two) drain electrodes 302a, 302b. The source electrodes 304a, 304b comprise a source force electrode S_{force} 304a configured to source current into the channel layer 306 and a source sense electrode Sₛₑₙₛ 304b configured to sink current into the channel layer 306. The drain electrodes 302a, 302b comprise a drain force electrode D_{force} 302a configured to source current from the channel layer 306, and a drain sense electrode Dₛₑₙₛ 302b configured to sink current from the channel layer 306.

The sense electrodes 302b, 304b measure the voltage at their contact point. They have a very high impedance and therefore negligible current is able to flow into them. As a result of virtually no current flow, there is virtually no potential difference on the channel layer 306 between where the sense electrodes 302b, 304b contact the channel layer 306 and where the force electrodes 302a, 304a contact the channel layer 306. The apparatus may be thought of such that each sense electrode 302b, 304b is configured for use in measuring the electrical potential of the channel layer 306 at the contact point between the corresponding force electrode 302a, 304a and the channel layer 306. In other examples, the force electrodes 302a, 304a and sense electrodes 302b, 304b may be ordered differently on the channel layer 306, for example, the sense electrodes 302b, 304b may be positioned between the two force electrodes 302a, 304a). Moreover, the arrangement of sense and force electrodes 302a, 302b, 304a, 304b in some examples may not be co-linear (i.e. the sense and force electrodes 302a, 302b, 304a, 304b may be arranged in a Hall bar-type geometry).

The source sense electrode 304b and drain sense electrode 302b are located, as shown in Figure 3a, wholly above the respective source contact gate 314 and drain contact gate 316. The source force electrode 304a and drain force electrode 302a are located, as shown in Figure 3a, partially above the respective source contact gate 314 and drain contact gate 316 and laterally adjacent each other, laterally separated from one another and vertically adjacent to the substrate side 310 of the channel layer 306 and contacting the channel layer 306. In this example, the channel gate 312, the source contact gate 314 and the drain contact gate 316 are coplanar, and all are embedded in a dielectric layer 318 located on the substrate side 308 of the channel layer 306.

Figure 3b shows an example with features in common with the example shown in Figure 1 b. A difference is that the example of Figure 3b comprises a plurality of (two) source electrodes 304a, 304b and a plurality of (two) drain electrodes 302a, 302b. There is a common contact gate G_{Cont} 320 which is configured to lower the contact resistance between the channel layer 306 and the source and drain electrodes 302a, 302b, 304a, 304b via application of a voltage V_{G_cont} thereto. The channel gate 312 is embedded in a dielectric layer 318 located on the substrate side 308 of the channel layer 306, between the channel layer 306 and the common contact gate 320. In this example, the apparatus 300 comprises the dielectric layer 318 vertically adjacent to the substrate side 308 of the channel layer 306 and the dielectric layer 318 is sandwiched between the channel layer 306 and a doped semiconducting (non-dielectric) layer 322. The doped semiconducting layer 322 is sandwiched between the dielectric layer 318 and the common contact gate 320.

In Figures 3a and 3b, regions in the channel layer of induced higher carrier density 352, 354 compared to an apparatus without contact gating, are shown in the regions of the channel layer 306 adjacent to the source and drain electrodes 302a, 302b, 304a, 304b as in Figures 1 a and 1b (that is, in the regions of the channel layer 306 between the force and sense electrodes (i.e. between the drain sense electrode 302b and the drain force electrode 302a, and between the source sense electrode 304b and the source force electrode 304a) and the region of the channel layer 306 gated by the channel electrode (i.e. to the right of the drain force electrode 302a and to the left of the source force electrode 304a as shown in the figures)). Such regions provide improved electrical contact between the source and drain electrodes 302a, 302b, 304a, 304b and the channel layer 306.

Figures 4a and 4b illustrate examples of an apparatus 400 according to the present disclosure in which multiple drain electrodes 402a, 402b and multiple source electrodes 404a, 404b are located on the functionalisation side 410 of the channel layer 406. Features in common with previously described examples will not be discussed again in detail.

Figure 4a shows an example with features in common with the example shown in Figure 2a. A difference is that the example of Figure 4a comprises a plurality of (two) source electrodes 404a, 404b and a plurality of (two) drain electrodes 402a, 402b. The source electrodes 404a, 404b comprise a source force electrode S_{force} 404a and a source sense electrode Sₛₑₙₛ 404b. The drain electrodes 402a, 402b comprise a drain force electrode D_{force} 402a and a drain sense electrode Dₛₑₙₛ 402b. These electrodes are described in relation to the example shown in Figure 3a.

Figure 4b shows an example with features in common with the example shown in Figure 2b. A difference is that the example of Figure 4b comprises a plurality of (two) source electrodes 404a, 404b and a plurality of (two) drain electrodes 402a, 402b. There is a common contact gate G_{Cont} 420 which is configured to lower the contact resistance between the channel layer 406 and the source and drain electrodes 402a, 402b, 404a, 404b via application of a voltage V_{G_cont} thereto.

Similarly to Figures 2a and 2b, in Figures 4a and 4b, the region of the channel layer vertically adjacent to the drain electrode 452 and the region of the channel layer vertically adjacent to the source electrode 454 are channel layer regions which experience a higher electric field when a contact gate voltage V_{G_cont} is applied to the source and drain contact gates 416, 414. The regions 452, 454 are located in the channel layer 406 where the channel layer 406 is vertically adjacent to the overlying drain and source electrodes 402a, 402b, 404a, 404b. The higher electric field induces a higher carrier density in these regions 452, 454 due to increased doping levels, to provide a reduced contact resistivity between the source and drain electrodes 402a, 402b, 404a, 404b and the channel layer 406 compared with an apparatus without contact gating.

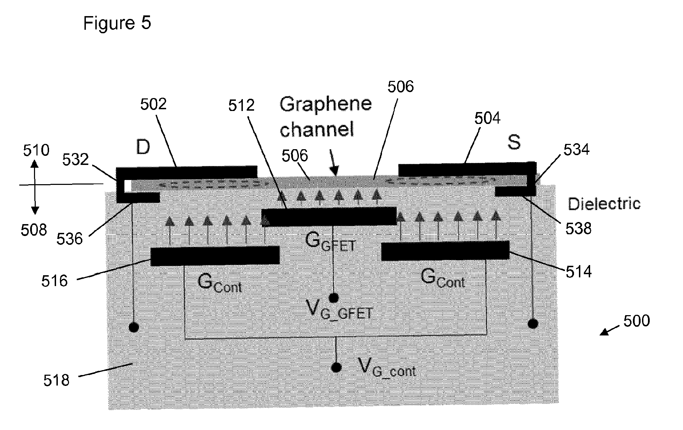

Figure 5 shows an example with features in common with the example shown in Figure 1a. The drain electrode 502, 536 may be thought of as a composite electrode with a portion 502 located on the functionalisation side 510 of the channel layer 506, connected (for example, by a via 532) to a portion 536 location on the substrate side 508 of the channel layer 506. Similarly, the source electrode 504, 538 may be thought of as a composite electrode with a portion 504 located on the functionalisation side 510 of the channel layer 506, connected (for example, by a via 534) to a portion 538 location on the substrate side 508 of the channel layer 506.

As shown in Figure 5, the drain contact gate 516 maintains a line-of-sight through the dielectric 518 and the channel layer 506 to the functionalisation side portion of the drain electrode 502 without being substantially obscured by the substrate side portion of the drain electrode 536. Similarly, the source contact gate 514 maintains a line-of-sight through the dielectric 518 and the channel layer 506 to the functionalisation side portion of the source electrode 504 without being substantially obscured by the substrate side portion of the source electrode 538. As before, the term "line-of-sight" is intended to mean that the electric field path between those two objects is not shielded or substantially disrupted by an electrically conducting object/layer.

The configuration of source electrode 504, 538 and drain electrode 502, 536 shown in Figure 5 may provide an advantage that the contact resistance between the metal electrodes 504, 538; 502, 536 and the channel layer 506 edge as shown in Figure 5 may be lower than a contact resistance between two planar surfaces such as those shown in previously described examples.

Using the approaches described above may allow for efficient fabrication of a device structure (for example, electrodes with a graphene layer deposited on top) and, in certain examples, excellent performance from the use of pristine unpatterned graphene which has not been damaged in any deposition processes occurring after deposition of the graphene layer, and a low contact resistance even when contacting only from below the graphene layer, due to the contact gating. In an example of an array of electrical components, such as a sensor array, the use of a single continuous layer of graphene over all the components to act as respective channel layers for each component, as described herein, may provide an efficient array fabrication method.

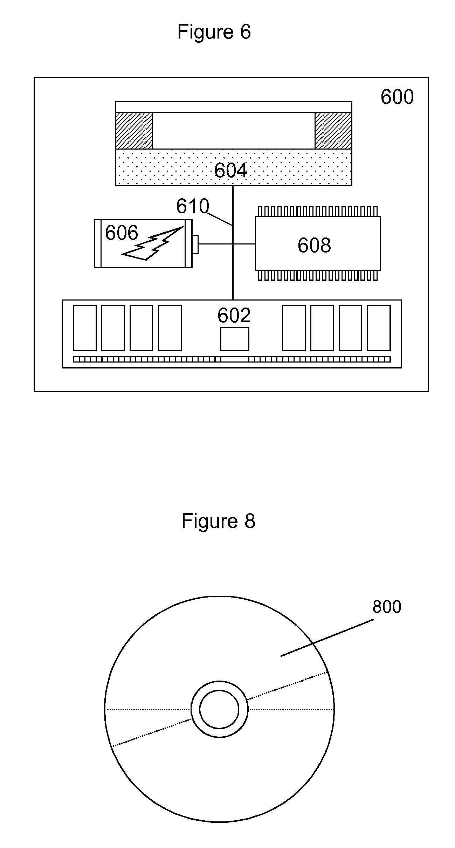

Figure 6 illustrates schematically another example of the present apparatus 600. The apparatus 600 may be one or more of a circuit board, a sensor, a biosensor, an optical sensor, an electronic device, a portable electronic device, a portable telecommunications device, a mobile phone, a personal digital assistant, a tablet, a desktop computer, a laptop computer, a server, a smartphone, a smartwatch, smart eyewear, a medical imaging device, a night-vision device, or a module for one or more of the same. In the example shown, the apparatus 600 comprises a storage medium 602, a power source 606, a processor 608, and electrical connection between the component parts 602, 604, 606, 608. The apparatus 600 also comprises an apparatus 604 according to the aforementioned examples, so as to itself comprise a drain electrode, a source electrode, and a channel layer, the drain electrode and source electrode in respective electrical contact with the channel layer to allow a flow of charge carriers between the source electrode and the drain electrode using the channel layer, the channel layer having opposing substrate and functionalisation sides; a channel gate configured to modulate the conductivity of the channel layer via application of a voltage thereto; and at least one contact gate configured to lower a contact resistance between the channel layer and at least one of the source electrode and the drain electrode via application of a voltage thereto; wherein the channel gate and the at least one contact gate are provided on the substrate side, opposing the functionalisation side, of the channel layer.

The processor 608 is configured for general operation of the apparatus 600 by providing signalling to, and receiving signalling from, the other components to manage their operation. The storage medium 602 is configured to store computer code configured to perform, control or enable operation of the apparatus 600. The storage medium 602 may also be configured to store settings for the other components. The processor 608 may access the storage medium 602 to retrieve the component settings in order to manage the operation of the other components.

Under the control of the processor 608, the power source 606 may be configured to apply a voltage to the channel gate of the apparatus 604 to modulate the conductivity of the channel layer therein. The same power source 608, or as separate power source (not shown) may be configured to apply a voltage to the at least one contact gate of the apparatus 604, the voltage being configured to lower a contact resistance between the channel layer and at least one of the source electrode and the drain electrode of the apparatus 604.

The processor 608 may be a microprocessor, including an Application Specific Integrated Circuit (ASIC). The storage medium 602 may be a temporary storage medium such as a volatile random access memory. The storage medium 602 may otherwise be a permanent storage medium 602 such as a hard disk drive, a flash memory, or a non-volatile random access memory. The power source 606 may comprise one or more of a primary battery, a secondary battery, a capacitor, a supercapacitor and a battery-capacitor hybrid.

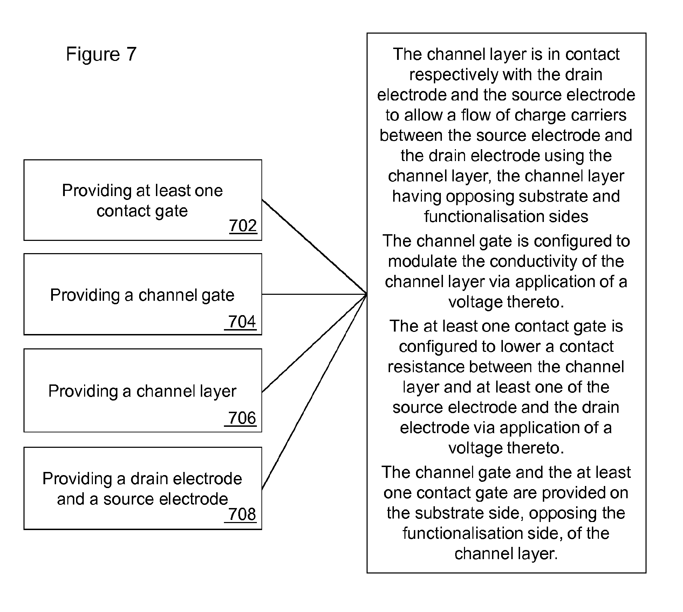

Figure 7 shows a flow diagram illustrating the method comprising providing respective at least one contact gate 702, a channel gate 704, a channel layer 706, a drain electrode and a source electrode 708 such that:
the channel layer is in contact respectively with the drain electrode and the source electrode to allow a flow of charge carriers between the source electrode and the drain electrode using the channel layer, the channel layer having opposing substrate and functionalisation sides;
the channel gate is configured to modulate the conductivity of the channel layer via application of a voltage thereto;
the at least one contact gate is configured to lower a contact resistance between the channel layer and at least one of the source electrode and the drain electrode via application of a voltage thereto; and
the channel gate and the at least one contact gate are provided on the substrate side, opposing the functionalisation side, of the channel layer.

Providing the channel layer in contact respectively with the drain electrode and the source electrode may include transfer of a thin film that has been formed on a different substrate. The thin film may be formed through deposition of a thin film using vapour deposition techniques such as chemical vapour deposition, atomic layer deposition, physical vapour deposition, or could be formed from solution of substantially two-dimensional platelets using wet-coating, printing or Langmuir-Blodgett techniques. The thin film may comprise graphene.

In the example of using a graphene layer for the channel layer, the graphene may be transferred onto the apparatus to form the channel layer, for example, by:
1. CVD growth of graphene on both surfaces of a metal catalyst foil such as copper foil
2. Coating one surface of the graphene/Cu foil with a protective polymer layer such as PMMA
3. Removing the graphene from the second surface of the graphene/Cu foil
4. Removing the copper by wet chemical etching, followed by cleaning and rinsing
5. Applying the protective layer/graphene while still wet to the target substrate and drying
6. Removing the protective layer using a solvent such as acetone or by thermal treatment
7. Thermally annealing the graphene on target substrate to improve adhesion

In other examples, the channel layer may be applied by deposition methods such as wet-coating (spin coating, bar coating, spray coating), printing (inkjet printing, aerosol jet deposition, gravure printing, flexographic printing), or dry coating (thermal evaporation, sputter-coating). The application of the channel layer may be performed by any two-dimensional material handling process.

The formation of the source and drain electrodes, channel gate, and one or more contact gates, may be achieved by any appropriate conductor or semiconductor fabrication process, such as photolithography, which will be known to those skilled in the art.

Figure 8 illustrates schematically a computer/processor readable medium 800 providing a program according to an example. In this example, the computer/processor readable medium is a disc such as a digital versatile disc (DVD) or a compact disc (CD). In other examples, the computer readable medium may be any medium that has been programmed in such a way as to carry out an inventive function. The computer program code may be distributed between the multiple memories of the same type, or multiple memories of a different type, such as ROM, RAM, flash, hard disk, solid state, etc. The computer/processor readable medium 800 may include instructions for fabrication of the apparatus of Figures 1a, 1b, 2a, 2b, 3a, 3b, 4a, 4b, 5 or 6.

Any mentioned apparatus/device and/or other features of particular mentioned apparatus/device may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/ functional units.

In some examples, a particular mentioned apparatus/device may be pre-programmed with the appropriate software to carry out desired operations, and wherein the appropriate software can be enabled for use by a user downloading a "key", for example, to unlock/enable the software and its associated functionality. Advantages associated with such examples can include a reduced requirement to download data when further functionality is required for a device, and this can be useful in examples where a device is perceived to have sufficient capacity to store such pre-programmed software for functionality that may not be enabled by a user.

Any mentioned apparatus/circuitry may have other functions in addition to the mentioned functions, and that these functions may be performed by the same apparatus/circuitry. One or more disclosed aspects may encompass the electronic distribution of associated computer programs and computer programs (which may be source/transport encoded) recorded on an appropriate carrier (e.g. memory, signal).

Any "computer" described herein can comprise a collection of one or more individual processors/processing elements that may or may not be located on the same circuit board, or the same region/position of a circuit board or even the same device. In some examples one or more of any mentioned processors may be distributed over a plurality of devices. The same or different processor/processing elements may perform one or more functions described herein.

The term "signalling" may refer to one or more signals transmitted as a series of transmitted and/or received electrical/optical signals. The series of signals may comprise one, two, three, four or even more individual signal components or distinct signals to make up said signalling. Some or all of these individual signals may be transmitted/received by wireless or wired communication simultaneously, in sequence, and/or such that they temporally overlap one another.

With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.

The applicant hereby discloses in isolation each individual feature described herein and any combination of two or more such features, to the extent that such features or combinations are capable of being carried out based on the present specification as a whole, in the light of the common general knowledge of a person skilled in the art, irrespective of whether such features or combinations of features solve any problems disclosed herein, and without limitation to the scope of the claims. The applicant indicates that the disclosed aspects/examples may consist of any such individual feature or combination of features. In view of the foregoing description it will be evident to a person skilled in the art that various modifications may be made within the scope of the disclosure.

While there have been shown and described and pointed out fundamental novel features as applied to examples thereof, it will be understood that various omissions and substitutions and changes in the form and details of the devices and methods described may be made by those skilled in the art without departing from the scope of the disclosure. For example, it is expressly intended that all combinations of those elements and/or method steps which perform substantially the same function in substantially the same way to achieve the same results are within the scope of the disclosure. Moreover, it should be recognised that structures and/or elements and/or method steps shown and/or described in connection with any disclosed form or examples may be incorporated in any other disclosed or described or suggested form or example as a general matter of design choice. Furthermore, in the claims means-plus-function clauses are intended to cover the structures described herein as performing the recited function and not only structural equivalents, but also equivalent structures. Thus although a nail and a screw may not be structural equivalents in that a nail employs a cylindrical surface to secure wooden parts together, whereas a screw employs a helical surface, in the environment of fastening wooden parts, a nail and a screw may be equivalent structures.

## Claims

1. An apparatus comprising:
a drain electrode, a source electrode, and a channel layer, the drain electrode and source electrode in respective electrical contact with the channel layer to allow a flow of charge carriers between the source electrode and the drain electrode using the channel layer, the channel layer having opposing substrate and functionalisation sides;
a channel gate configured to modulate the conductivity of the channel layer via application of a voltage thereto; and
at least one contact gate configured to lower a contact resistance between the channel layer and at least one of the source electrode and the drain electrode via application of a voltage thereto;
wherein the channel gate and the at least one contact gate are provided on the substrate side, opposing the functionalisation side, of the channel layer.

2. The apparatus of claim 1, wherein the source electrode and the drain electrode are located adjacent to the channel layer on the substrate side of the channel layer.

3. The apparatus of claim 1, wherein the source electrode and the drain electrode are located adjacent to the channel layer on the functionalisation side of the channel layer.

4. The apparatus of any preceding claim, wherein the channel layer comprises a two-dimensional material.

5. The apparatus of any preceding claim, wherein the channel gate and the at least one contact gate are coplanar.

6. The apparatus of any preceding claim, wherein the at least one contact gate is a common gate configured to lower the contact resistance between the channel layer and both the source electrode and the drain electrode via application of a common voltage thereto.

7. The apparatus of any preceding claim, wherein the channel gate is embedded in a dielectric layer located on the substrate side of the channel layer, between the channel layer and the at least one contact gate.

8. The apparatus of any preceding claim, wherein the at least one contact gate is embedded in a dielectric layer located on the substrate side of the channel layer.

9. The apparatus of any preceding claim, comprising:
a dielectric layer adjacent to the substrate side of the channel layer, the dielectric layer sandwiched between the channel layer and a doped semiconducting (non-dielectric) layer.

10. The apparatus of any preceding claim, wherein the at least one contact gate and the channel gate are embedded in different planes in a dielectric on the substrate side of the channel layer, the channel gate located closer to the channel layer than the at least one contact gate.

11. The apparatus of any preceding claim, wherein the source electrode, the drain electrode, the channel gate and the channel layer are configured as part of a field effect transistor (FET).

12. The apparatus of any preceding claim, wherein the apparatus comprises a plurality of source electrodes and/or a plurality of drain electrodes.

13. The apparatus of any preceding claim, wherein the channel layer is functionalised by the addition to the functionalisation side of the channel layer by one or more of:
molecules such that the apparatus is configured for use as a biosensor; and
quantum dots such that the apparatus is configured for use as an optical sensor.

14. The apparatus of any preceding claim, wherein the apparatus is a circuit board, a sensor, a biosensor, an optical sensor, an electronic device, a portable electronic device, a portable telecommunications device, a mobile phone, a personal digital assistant, a tablet, a desktop computer, a laptop computer, a server, a smartphone, a smartwatch, smart eyewear, a medical imaging device, a night-vision device, or a module for one or more of the same.

15. A method comprising:
providing respective at least one contact gate, a channel gate, a channel layer, a drain electrode and a source electrode such that:
the channel layer is in contact respectively with the drain electrode and the source electrode to allow a flow of charge carriers between the source electrode and the drain electrode using the channel layer, the channel layer having opposing substrate and functionalisation sides;
the channel gate is configured to modulate the conductivity of the channel layer via application of a voltage thereto,
the at least one contact gate is configured to lower a contact resistance between the channel layer and at least one of the source electrode and the drain electrode via application of a voltage thereto; and
the channel gate and the at least one contact gate are provided on the substrate side, opposing the functionalisation side, of the channel layer.
